Europäisches Patentamt

European Patent Office

Office européen des brevets

(11) Publication number: 0 582 974 A2

# EUROPEAN PATENT APPLICATION

(21) Application number: 93112602.3

(22) Date of filing: 05.08.93

(51) Int. Cl.5: G11C 11/419

(30) Priority: 08.08.92 KR 1424492

(43) Date of publication of application:
16.02.94 Bulletin 94/07

(84) Designated Contracting States:
DE FR GB IT

(71) Applicant: SAMSUNG ELECTRONICS CO., LTD.
416 Maetan-3 Dong,
Paldal-ku
Suwon-city, Kyungki-do 441-373(KR)

(72) Inventor: Jung, Chul-Min
18-1, Songpa-dong,
Songpa-gu
Seoul(KR)
Inventor: Choi, Jin-Young
Limkwang Apt. 10-1024,
Maetan 3-dong, Paldal-gu
Suwon-city, Kyungki-do(KR)
Inventor: Suh, Young-Ho
494, Wooman-dong,
Jangahn-gu
Suwon-city, Kyungki-do(KR)
Inventor: Lim, Hyung-Kyu
Woosung 2cha Apt. 205-1001,
Daechi-dong
Kangnam-gu, Seoul(KR)

(74) Representative: Patentanwälte Grünecker,
Kinkeldey, Stockmair & Partner
Maximilianstrasse 58
D-80538 München (DE)

(54) Current sensing circuit of a semiconductor memory device.

(57) A current sensing circuit of a static random access memory in a semiconductor memory device includes a current-to-voltage converter consisting of NMOS transistors of which channels are respectively connected between each data line of a pair of data lines and an input node of a voltage sense amplifier and their gates are cross-coupled, so that current can be quickly converted into a voltage to thereby secure speedy sensing operation of data stored in a memory cell.

(PRIOR ART)
*FIG. 1*

EP 0 582 974 A2

## BACKGROUND OF THE INVENTION

The present invention relates to a semiconductor memory device, and more particularly to a current sensing circuit of a static random access memory.

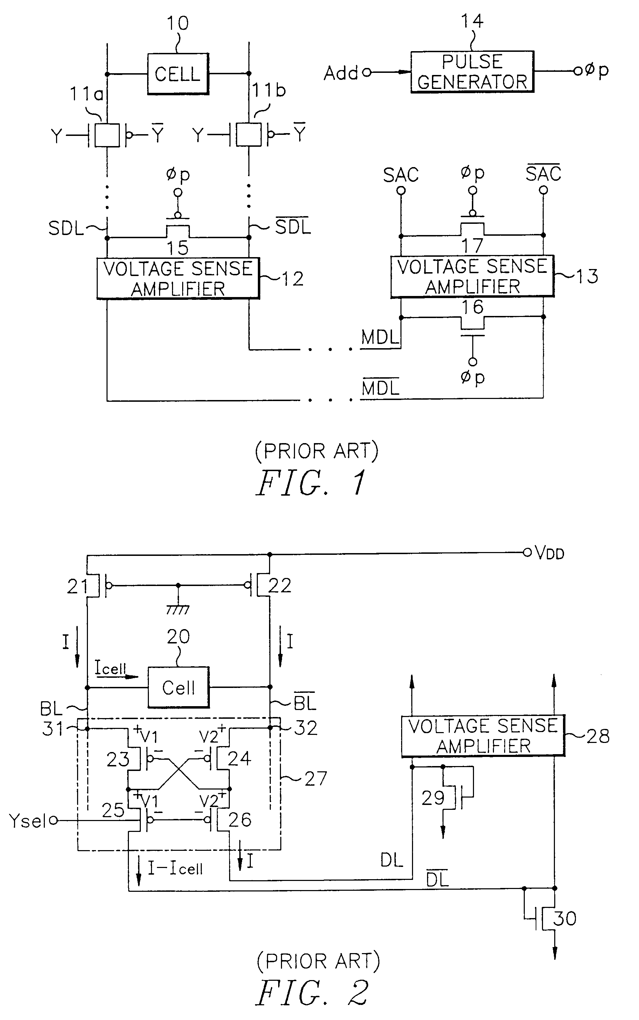

FIG. 1 is a circuit diagram showing a voltage sensing circuit of a conventional static random access memory. Here, during a data read-out operation, a voltage difference corresponding to data information read from a cell 10 appears between section data lines SDL and $\overline{SDL}$, which ranges approximately from 50 to 200mV. The voltage difference between section data lines SDL and $\overline{SDL}$ is sensed by a voltage sense amplifier 12.

At this time, the voltage differences of the section data lines SDL between $\overline{SDL}$ and main data lines MDL between $\overline{MDL}$ are considerably increased, respectively. To prevent the effect of such voltage difference, for a succeeding sensing operation, the voltages of the section data lines SDL, $\overline{SDL}$ and the voltages of the main data lines MDL, $\overline{MDL}$ should be equalized, using an equalizing pulse generator 14 using an address transition detector (ATD). The voltages of the section data lines SDL, $\overline{SDL}$ and the voltages of the main data lines MDL, $\overline{MDL}$ are equalized by supplying an equalizing pulse $\phi P$ from the equalizing pulse generator 14 to a gate of a MOS transistor 15 having its channel connected between the section data lines SDL and $\overline{SDL}$, and a gate of a MOS transistor 16 having its channel connected between the main data lines MDL and $\overline{MDL}$, respectively. In the above-described conventional voltage sensing circuit of Fig. 1, since the data line pairs are equalized for each sensing operation, the equalizing pulse should be supplied per every sensing operation, using the address transition detector. Accordingly, the delay time is generated owing to pulse margins, thereby degrading the operation speed.

A sensing circuit has been suggested by Evert Seevinck for eliminating the above-stated problem and accelerating a sensing speed, which is disclosed in IEEE Journal of Solid-state Circuits (Vol. 26, No. 4, April 1991).

FIG. 2 shows a current sensing circuit suggested by Evert Seevinck.

Here, the current sensing circuit of Fig. 2 includes first and second PMOS transistors 21 and 22 having channels connected between a power supply voltage $V_{DD}$ and bit lines BL, $\overline{BL}$ and whose gates are connected to a ground voltage; a static RAM cell 20; a current sense amplifier 27 consisting of third to sixth PMOS transistors 23, 24, 25 and 26 which are connected between the bit lines BL, $\overline{BL}$ and data lines DL, $\overline{DL}$, and have the same size; first and second NMOS clamp transistors 29 and 30 having channels connected between each of the data lines DL and $\overline{DL}$ and the ground voltage, and whose gates are diode-connected; and a voltage sense amplifier 28 for sensing a voltage difference between the data lines DL and $\overline{DL}$. The first and second PMOS transistors 21 and 22 are bit line load means which may be replaced with NMOS transistors having gates connected to the power supply voltage source. The current sense amplifier 27 is selected by connecting a node Ysel connected to the fifth and sixth PMOS transistors 25 and 26 with the ground voltage. By this operation, current flows through the first and second PMOS transistors 21 and 22. It is assumed that access current Icell flows through bit line BL during an access operation of the cell 20. At this time, each gate-to-source voltage of the third and fifth PMOS transistors 23 and 25 is the same by voltage $V_1$ to each other. This is because the sizes and channel currents of the two PMOS transistors 23 and 25 are identical to each other and they are in a saturated state. With the same reason, each gate-to-source voltage of the fourth and sixth PMOS transistors 24 and 26 are the same by voltage $V_2$ to each other. Since the node Ysel is connected to the ground voltage, the voltages of a first node 31 on the bit line BL and a second node 32 on the bit line $\overline{BL}$ are $V_1 + V_2$, respectively. In other words, the potentials of the bit lines BL and $\overline{BL}$ are in the same level regardless of the data state of the cell 20 whether the data is in logic "high" state or logic "low" state. As described above, since the potentials of the bit lines BL and $\overline{BL}$ are the same to each other, bit line load currents I flowing through the first and second PMOS transistors 21 and 22 which are the bit line load means are also the same to each other.

By the access current $I_{cell}$ of the cell 20, currents I-$I_{cell}$ and I flow through the bit lines BL and $\overline{BL}$, respectively, provided between the cell 20 and the current sense amplifier 27. Here, much more current flows into the right line $\overline{BL}$ of the current sense amplifier 27 which has a "high" node in the cell 20 than in the left line BL thereof, assuming that an instantaneous current discharge caused by a bit line capacitor is ignored. At this point, the currents flowing through the left line BL and right line $\overline{BL}$ of the current sense amplifier 27 are I-$I_{cell}$ and I, respectively, and the difference between them equals to the access current $I_{cell}$. Drain currents of the fifth and sixth PMOS transistors 25 and 26 are transmitted to the data lines DL and $\overline{DL}$, respectively. Here, the current difference between the data lines DL and $\overline{DL}$ equals to the access current $I_{cell}$.

The above operation is performed under the condition that the PMOS transistors 21, 22 employed as the load means and the current sense amplifier 27 are assumed as ideal current sources.

However, in an actual operation, since the currents I of the bit line BL and $\overline{BL}$ is replenished with the PMOS transistors 21 and 22, the difference between the currents flowing through the left and right lines of the sense amplifier 27 becomes smaller than the access current $I_{cell}$. The currents transmitted to the data lines DL and $\overline{DL}$ are converted into voltages by means of the first and second NMOS clamp transistors 29 and 30, thereby being supplied to the input of the voltage sense amplifier 28.

As can be understood in the above description, the voltages of the bit fines BL and $\overline{BL}$ are maintained in the same level by means of the current sense amplifier 27 having the flip-flop structure, so that there is no need to equalize the bit lines BL and $\overline{BL}$ during the data read-out operation of the cell 20.

However, such a sensing circuit shown in FIG. 2 converts current into a voltage, using the NMOS clamp transistors 29, 30, so that the voltage variation is $R^*\sqrt{(I)} + a$ (where R is a proportional constant ) when the variation of the current is set as I. Consequently, a great voltage difference of about 50mV cannot be supplied to the voltage sense amplifier 28 which makes the sensing circuit unsuitable for an actual chip design and product manufacturing. Further, in the sensing circuit shown in FIG. 2, it requires much time for the voltage amplification after the current is converted into the voltage.

## SUMMARY OF THE INVENTION

Accordingly, it is an object of the present invention to provide a current-to-voltage converter capable of quickly converting current into a voltage.

It is another object of the present invention to provide a current sensing circuit having a current-to-voltage converter capable of quickly converting current into a voltage.

To achieve the above objects of the present invention, there is provided a current sensing circuit of a semiconductor memory device having a current sense amplifier connected to a memory cell and a pair of data lines connected to an output stage of said current sense amplifier, said current sensing circuit having a current-to-voltage converter comprising: load means formed between a power supply voltage source and predetermined output nodes, and controlled by means of a predetermined block selection signal; driver means formed between said pair of data lines and said output nodes for converting a current difference conveyed on said pair of data lines into a voltage; and pull-down means connected to said pair of data lines.

## BRIEF DESCRIPTION OF THE DRAWINGS

The above objects and other advantages of the present invention will become more apparent by describing in detail a preferred embodiment thereof with reference to the attached drawings in which:
FIG. 1 shows a voltage sensing circuit according to a conventional technique;
FIG. 2 shows a current sensing circuit according to a conventional technique;
FIG. 3 shows a current sensing circuit according to the present invention; and
FIG. 4 is a block diagram in which the current sensing circuit of the present invention is adopted.

## DETAILED DESCRIPTION OF THE INVENTION

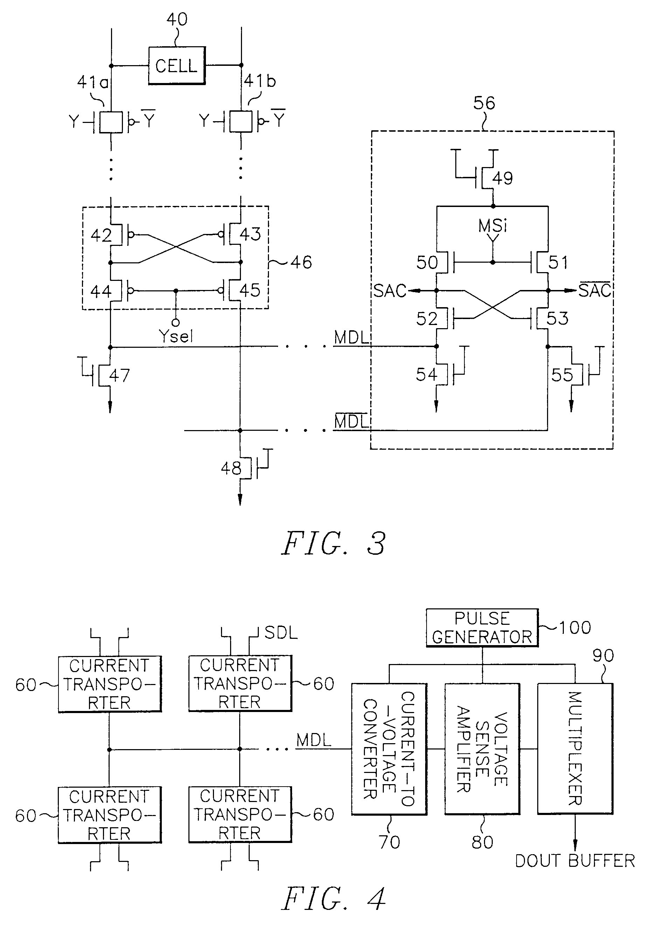

FIG. 3 illustrates a current sensing circuit according to the present invention, which includes a memory cell 40 connected between bit lines; column selection transistors 41a and 41b for selecting the memory cell 40; a current sense amplifier 46 for transmitting current of a selected bit line to main data lines MDL and $\overline{MDL}$ ; and a current-to-voltage converter 56 for converting current between the main data lines MDL and $\overline{MDL}$ into voltage. The current-to-voltage converter 56 includes NMOS transistors 50,51 as load elements formed between an internal voltage source and output nodes SAC, $\overline{SAC}$ and controlled by a block selection signal MSi; NMOS transistors 52, 53 as driver elements formed between the main data lines MDL and $\overline{MDL}$ and the output nodes for performing the voltage amplification of the difference of currents between the main data lines MDL and $\overline{MDL}$ ; and NMOS transistors 54, 55 as pull-down elements connected to the MDL and $\overline{MDL}$ , respectively. The current-to-voltage converter 56 is stable with respect to the variations of the process, by consisting of NMOS transistors.

The operational characteristic according to the present invention of Fig. 3 will be described hereinafter. During an access operation of the cell 40, a voltage difference corresponding to data information read from a cell 40 appears on a pair of bit lines. The current difference is transmitted to the main data lines MDL and $\overline{MDL}$ through the current sense amplifier 46. The operation of the current sense amplifier 46 is the same as that described with reference to FIG. 2. The current difference between the main data lines MDL and $\overline{MDL}$ is converted into a voltage difference by the NMOS clamp transistors 54 and 55 when the block selection signal MSi is logic "low" state, and the voltage difference between the main data lines MDL and $\overline{MDL}$ is eliminated by the cross-coupled NMOS transistors 52 and 53 when the block selection signal MSi is logic "high" state. Consequently, the current difference of the main data lines MDL and $\overline{MDL}$ is amplified and ouputted as the voltage difference between output nodes SAC and $\overline{SAC}$ by the current-to-voltage converter 56. Also, the above-described current-to-voltage converter 56 has a peculiar function for equalizing the voltages of the main data fines MDL and $\overline{MDL}$, thus does not require an equalizing circuit between the main data lines MDL and $\overline{MDL}$. If the current difference between the main data lines MDL and $\overline{MDL}$ exceeds a predetermined level, the NMOS transistor 49 restrains a latch operation. By the above operation, the output voltages SAC and $\overline{SAC}$ of the current-to-voltage converter 56 have a difference of about 100mV under the condition that the temperature is 100°C and the power supply voltage is 4.2V. This insignificant difference can be restored by the currents of the main data lines MDL and $\overline{MDL}$ in the opposite direction when the load of the load transistors 50 and 51 is slight. Due to this restorable characteristic, even if a noise is applied to a read-out circuit, different from the conventional sense amplifier of latch-type, the current-to-voltage converter can instantly restore its original state. Even though the current-to-voltage converter 56 has a latch structure, it cannot be fully latched owing to the operation of the pull-up transistor 49. In addition to this, since the main data lines MDL and $\overline{MDL}$ have no voltage difference, the speed delay by the load of the main data lines MDL and $\overline{MDL}$ does not appear, either.

Furthermore, the voltages of the main data lines MDL and $\overline{MDL}$ are constantly maintained regardless of the output voltages of the current-to-voltage converter 56, the current sensing operation can be successively carried out. In the meantime, the sensing speed can be accelerated by adding a circuit capable of equalizing the output voltages SAC and $\overline{SAC}$ of the current-to-voltage converter 56.

FIG. 4 is a block diagram showing the present invention adopted thereto, wherein a current-to-voltage converter 70 according to the present invention is connected to a conventional current transporter 60 and a voltage sense amplifier 80. As shown in FIG. 4, the current-to-voltage converter 70 and the voltage sense amplifier 80 are placed nearest to a pulse generator 100 within a chip, thereby securing a sufficiently rapid speed.

As described above, the present invention is effective by providing a current-to-voltage converter capable of quickly converting current to a voltage in a current sensing circuit, such that the current-to-voltage converter includes NMOS transistors having channels respectively connected between each data line of a pair of data lines and an output node, and cross-coupled gates.

While the present invention has been particularly shown and described with reference to particular embodiments thereof, it will be understood by those skilled in the art that various changes in form and details may be effected therein without departing from the spirit and scope of the invention as defined by the appended claims.

**Claims**

1. A current sensing circuit of a semiconductor memory device having a current sense amplifier connected to a memory cell and a pair of data lines connected to an output stage of said current sense amplifier, said current sensing circuit having a current-to-voltage converter comprising:
    load means formed between a power supply voltage source and predetermined output nodes, and controlled by means of a predetermined block selection signal;
    driver means formed between said pair of data lines and said output nodes for converting a current difference conveyed on said pair of data lines into a voltage; and
    pull-down means connected to said pair of data lines.

2. A current sensing circuit as claimed in claim 1, wherein said current-to-voltage converter further comprises a pull-up transistor having its channel connected to said power supply voltage source;
    whereby a power source voltage from said pull-up transistor is supplied to said current-to-voltage converter.

3. A current sensing circuit as claimed in claim 2, wherein said load means is comprised of first and second load transistors having channels parallel-coupled to said pull-up transistor and whose gates are commonly connected to said block selection signal.

4. A current sensing circuit as claimed in claim 2, wherein said driver means is comprised of first and second driver transistors respectively connected between said first and second load transistors and said pair of data lines, and latched to each other.

5. A current sensing circuit as claimed in claim 4, wherein said pull-down means is comprised of first and second pull-down transistors having gates respectively connected to said power supply voltage, and whose respective channels are connected between said pair of data lines and ground voltage.

6. A current sensing circuit as claimed in claim 5, wherein said pull-up transistor, said first and second load transistors, said first and second driver transistors, and first and second pull-down transistors are constituted by NMOS transistors, respectively.

7. In a semiconductor memory device having a memory cell, a pair of bit lines connected to said memory cell, and a voltage sense amplifier for performing voltage amplification of data, said semiconductor memory device further comprising:

a current sense amplifier formed on said pair of bit lines for sensing and outputting currents conveyed on said bit lines;

a pair of data lines connected to an output stage of said current sense amplifier; and

a current-to-voltage converter connected between said pair of data lines and said voltage sense amplifier for performing a voltage amplification of said currents conveyed on said data lines.

(PRIOR ART)

*FIG. 1*

(PRIOR ART)

*FIG. 2*

*FIG. 3*

*FIG. 4*